# EUROPEAN PATENT SPECIFICATION

(11) **EP 3 223 267 B1**
(45) Date of publication and mention of the grant of the patent: **15.06.2022**
(21) Application number: 15750915.9
(22) Date of filing: 17.03.2015
(51) Int. Cl.: G09G 3/3266, G11C 19/28

(54) **DISPLAY DEVICE COMPRISING A SHIFT REGISTER**
ANZEIGEVORRICHTUNG MIT EINEM SCHIEBEREGISTER
DISPOSITIF D'AFFICHAGE COMPRENANT UN REGISTRE À DÉCALAGE

(30) Priority: 19.11.2014 CN 201410664680
(43) Date of publication of application: 27.09.2017
(73) Proprietor: BOE Technology Group Co., Ltd., Beijing 100015 (CN)
(72) Inventor: MA, Zhanjie, Beijing 100176 (CN)
(74) Representative: Isarpatent
(86) International application number: PCT/CN2015/074352
(87) International publication number: WO 2016/078264

(56) References cited:
- CN-A- 102 982 777
- CN-A- 103 000 155
- CN-A- 103 236 272
- CN-A- 103 325 353
- CN-A- 104 361 860
- CN-U- 202 332 230
- CN-U- 204 178 680
- US-A1- 2006 013 352
- US-A1- 2007 079 191
- US-A1- 2007 258 557
- US-A1- 2010 259 525
- US-A1- 2012 133 574
- US-A1- 2014 266 304

## Description

### TECHNICAL FIELD

The present disclosure relates to the field of liquid crystal display technology, and in particular to a display device including a gate driving circuit, the gate driving circuit including a shift register, and the shift register including a shift register unit.

### BACKGROUND

In an Organic Light-Emitting Diode (OLED for short hereinafter) display device, each pixel may emit light independently to perform a display under control of film transistors. A shift register unit for controlling light emission is required in a gate driving circuit of the OLED display device, where the shift register unit for controlling light emission realizes that the light emission of pixels may always be turned on in a phase of light emission of pixels by outputting a turn-off signal at one pulse period of time and outputting turn-on signals during all the other period of time.

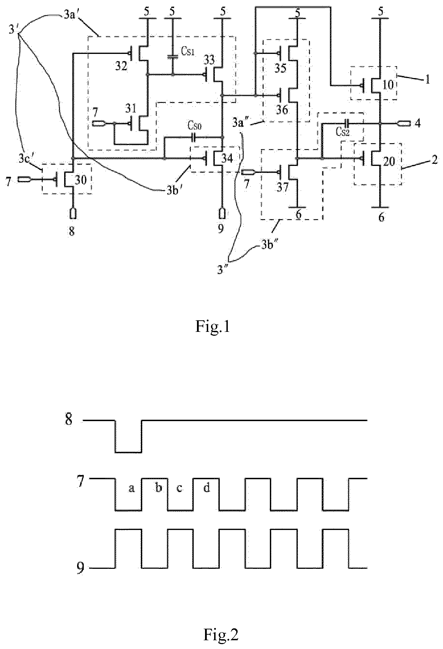

Fig.1 is a circuit diagram of an existing shift register unit for controlling light emission. As shown in Fig.1, the shift register unit for controlling light emission includes a first module 1, a second module 2, a first control module 3' and a second control module 3" . The first module 1 including a first control transistor 10 is configured to make an output terminal 4 of the shift register unit in a current stage output a high level signal, where a first electrode of the first control transistor 10 is connected to a high level signal input terminal 5, a second electrode thereof is connected to the output terminal 4. The second module 2 including a second control transistor 20 is configured to make an output terminal 4 of the shift register unit in the current stage output a low level signal, where a first electrode of the second control transistor 20 is connected to a low level signal input terminal 6, and a second electrode thereof is connected to the output terminal 4. The first control module 3' and the second control module 3" are configured to control on and off states of the first control transistor 10 and the second control transistor 20. The first control module 3' includes an initial signal module 3c' , a first capacitor C_{S0}, and a first sub-module 3a' and a second sub-module 3b' connected with the first capacitor Cso in parallel; the second control module 3" includes a third sub-module 3a" and a fourth sub-module 3b" ; the first sub-module 3a' and the second sub-module 3b' are connected to a gate electrode of the first control transistor 10, to control on and off states of the first control transistor 10. In addition, the first sub-module 3a' and the second sub-module 3b' are further connected to the third sub-module 3a" , to control on and off states of each transistor in the third sub-module 3a" ; the third sub-module 3a" and the fourth sub-module 3b" are connected to a gate electrode of the second control transistor 20, to control on and off states of the second control transistor 20. To be specific, the initial signal module 3c' includes a signal control transistor 30; the first sub-module 3a' includes a first transistor 31, a second transistor 32, a third transistor 33 and a second capacitor Csi; the second sub-module 3b' includes a fourth transistor 34; the third sub-module 3a" includes a fifth transistor 35 and a sixth transistor 36; the fourth sub-module 3b" includes a seventh transistor 37 and a third capacitor C_{S2}; a connection relation of the above transistors is shown in Fig.1.

A working principle of the shift register unit for controlling light emission may be illustrated hereinafter in conjunction with Fig.1 and Fig.2 in the case that each transistor in the shift register unit for controlling light emission and the film transistor for controlling the light emission of pixels are P-type transistors. To be specific, as shown in Fig.2, in a first phase a, an initial signal input into an initial signal input terminal 8 is at a low level, a first clock signal input into a first clock signal input terminal 7 is at a low level, and a second clock signal input into a second clock signal input terminal 9 is at a high level. In this case, the first control transistor 10 and each transistor in the third sub-module 3a" are in off states under control of the second sub-module 3b' , and the second control transistor 20 is in an on state under control of the fourth sub-module 3b" , thereby the low level signal input into the low level signal input terminal 6 may be output from the output terminal 4 via the second module 2, i.e., a turn-on signal may be output from the output terminal 4. In a second phase b, the initial signal turns to a high level, the first clock signal turns to a high level, and the second clock signal turns to a low level. In this case, the first control transistor 10 and each transistor in the third sub-module 3a" are in on states under control of the second sub-module 3b' , whereby the second control transistor 20 may be in an off state under control of the third sub-module 3a" , thereby the high level signal input into the high level signal input terminal 5 may be output from the output terminal 4 via the first module 1, i.e., a turn-off signal may be output from the output terminal 4. In a third phase c, the initial signal maintains in a high level, the first clock signal turns to a low level, and the second clock signal turns to a high level. In this case, the first control transistor 10 and each transistor in the third sub-module 3a" are in off states under control of the first sub-module 3a' , and the second control transistor 20 is in an on state under control of the fourth sub-module 3b" , thereby the low level signal input into the low level signal input terminal 6 may be output from the output terminal 4 via the second module 2, i.e., a turn-on signal may be output from the output terminal 4. In the fourth phase d, the initial signal maintains in a high level, the first clock signal turns to a high level, and the second clock signal turns to a low level. In this case, the first control transistor 10 and each transistor in the third sub-module 3a" are in off states under control of the first sub-module 3a' , and the second control transistor 20 is in an on state under control of the fourth sub-module 3b" , thereby the low level signal input into the low level signal input terminal 6 may be output from the output terminal 4 via the second module 2, i.e., a turn-on signal may be output from the output terminal 4. In the subsequent phases, the third phase c and the fourth phase d may be repeated continually, whereby all the signals output from the output terminal 4 may be turn-on signals.

In the shift register unit for controlling light emission hereinabove, the signal output of the shift register unit for controlling light emission is controlled by using a plurality of transistors (totally 10), i.e., the turn-off signal is output only at one pulse period of time, and the turn-on signals are output during the other period of time, therefore the shift register unit for controlling light emission may occupy a lot of space (i.e., occupy a wider border), and then it may not facilitate to realize a narrow border of a display device.

In US2006013352A1, a shift register is provided that is tolerant of variations or skew in its control clock signals. In even stages of the shift register, inverters are added respectively to the input terminal and the output terminal of a latch circuit. In addition, the shift register operates based on two control clock signals.

US2007258557A1 provides a shift register circuit having a plurality of shift registers connected in series, each shift register having a phase-shifting element and a pull-high element, wherein the phase-shifting element receives a first input signal, a first clock signal and a second clock signal, and the first clock signal and the second clock signal are complementary in phase. The pull-high element is used for pulling up an output signal to a high logic level, and includes a logic unit, wherein no current path is established in the pull-high element when the shift register is operated in any type of periods.

US2012133574A1 provides a shift register unit, a gate drive circuit and a display apparatus. The shift register unit comprises: input module for inputting first and second clock signals, frame start signal, high and low voltage signals, the first clock signal is identical with phase-inverted signal of the second clock signal within one frame; a processing module comprising multiple TFTs, for generating gate drive signal according to the first and second clock signals and frame start signal, controlling voltage of first node formed by TFTs lower than the low level of power supply signal during evaluation period of shift register unit, and resetting second node formed by TFTs to cut off transient DC path formed by input terminals of the high and low voltage signals, and at least one TFT in time; an output module for sending gate drive signal generated by the processing module. Document US2007079191A1 discloses the same.

CN103236272A provides a shift register unit and its driving method, a gate driving device and a display device. The shift register unit comprises: a signal input unit used for outputting a first level signal or a second level signal to the first end of a latch unit under control of an input signal and a reset signal; the latch unit used for latching the signal input by the signal input unit and outputting a latched processed signal to a pull-down unit; the pull-down unit used for outputting the first level signal or a pull-down signal to a signal output unit under control of the latched processed signal; and the signal output unit for receiving the signal sent by the pull-down unit, subjecting it to backward processing to serve as an output signal, and outputting a signal that is inverted to the output signal. Thus, the shift register circuit structure can be simplified, and is in favor of realizing a display panel narrow border.

In the disclosure of US2010259525A1, at least one embodiment of the present invention is directed to, even when external noise is applied to a shift register during all-on operation, preventing through-current from flowing in unit circuits and also to prevent increase in load on all-on control signal lines. When a high-level all-on control signal is provided to a unit circuit of a shift register, a transistor T3 is brought into off-state, so that a transistor T2 cannot output an on-voltage to a first output terminal. However, a transistor T24 is brought into on-state, so, that the first output terminal outputs an on-voltage to the exterior. On the other hand, a transistor T32 is brought into on-state, so that a second output terminal outputs an off-voltage to a unit circuit 11 in the next stage. At this time, the transistor T3 is kept in off-state, so that no through-current flows to the transistors T24 and T3.; At least one embodiment of the present invention is suitable for driver circuits or suchlike of display devices and imaging devices.

US2007/259525A1 disclosed a scan driving circuit and an organic light emitting display. A first scan driver having a plurality of first stages sequentially outputs a selection signal, and a second scan driver having a plurality of second stages sequentially outputs an emission signal. Each of the first and second stages are configured so as to have substantially zero static current, and operation speed can be optimized without significant increase in power consumption.

### SUMMARY

The present disclosure is to solve at least one of the technical issues existing in the prior art, where a display device as recited in independent claim 1 is provided. An advantageous embodiment is set out in dependent claim 2. An amount of transistors in the shift register unit may be reduced, thereby reducing a space occupied by the shift register unit (i.e., the border may be narrower) and then helping to realize a narrow border of a display device.

To achieve the objective of the present disclosure, a display device is provided, comprising a gate electrode and a gate driving circuit, wherein the gate driving circuit comprises a shift register. The shift register unit includes a first module, a second module, a control module, a high level signal input terminal, a low level signal input terminal and an output terminal of the shift register unit, wherein the first module including a first control transistor is configured to make an output terminal of the shift register unit in a current stage output a high level signal, where a gate electrode of the first control transistor is connected to the control module, a first electrode of the first control transistor is connected to a high level signal input terminal, a second electrode of the first control transistor is connected to the output terminal of the shift register unit in the current stage; the control module is configured to control on and off states of the first control transistor, wherein the control module comprises an initial signal module, a first capacitor and a first control module and a second control module connected with the first capacitor in parallel, a first end of the first capacitor is connected to the initial signal module, and a second end of the first capacitor is connected to the gate electrode of the first control transistor; and the second module including a second control transistor is configured to make an output terminal of the shift register unit of the stage output a low level signal, where a gate electrode and a first electrode of the second control transistor are both connected to a low level signal input terminal, and a second electrode of the second control transistor is connected to the output terminal of the shift register unit in the current stage.

The initial signal module includes a signal control transistor, where a gate electrode of the signal control transistor is connected to the first clock signal input terminal, a first electrode of the signal control transistor is connected to an initial signal input terminal, and a second electrode of the signal control transistor is connected to the first end of the first capacitor, the first control module and the second control module, wherein the initial signal module is configured to provide an initial signal to the first capacitor, the first control module and the second control module.

The first control module includes a second capacitor, a first transistor, a second transistor and a third transistor; where a gate electrode and a first electrode of the first transistor are both connected to the first clock signal input terminal, a second electrode of the first transistor is connected to a second electrode of the second transistor and a gate electrode of the third transistor; a gate electrode of the second transistor is connected to the second electrode of the signal control transistor, a first electrode of the second transistor is connected to the high level signal input terminal, and the second electrode of the second transistor is connected to a gate electrode of the third transistor; and the gate electrode of the third transistor is connected to a first end of the second capacitor, a second end of the second capacitor is connected to the high level signal input terminal, a first electrode of the third transistor is connected to the high level signal input terminal, and a second electrode of the third transistor is connected to the gate electrode of the first control transistor and the second end of the first capacitor.

The second control module includes a fourth transistor, where a gate electrode of the fourth transistor is connected to the second electrode of the signal control transistor and the first end of the first capacitor, a first end of the fourth transistor is connected to the second clock signal input terminal, and a second electrode of the fourth transistor is connected to the gate electrode of the first control transistor and the second terminal of the first capacitor.

The present disclosure has the following advantages:

In the shift register unit of the display device, the gate electrode of the second control transistor is connected to the low level signal input terminal, i.e., on and off states of the second control transistor is directly controlled by the low level signal, whereby it is not required to arrange specially an additional transistor to control the on and off states of the second control transistor respectively. Compared with the prior art, an amount of the transistors in the shift register unit of the display device provided by the present disclosure is reduced, thereby reducing a space required to be occupied by the shift register unit and then facilitating to realize a narrow border of the display device.

The shift register of the display device includes the shift register unit, whereby it is not required to arrange specially an additional transistor to control the on and off states of the second control transistor respectively. Compared with the prior art, an amount of the transistors is reduced, thereby reducing a space required to be occupied by the shift register and then helping to realize a narrow border of the display device.

The gate driving circuit of the display device includes the shift register, whereby it is not required to arrange specially an additional transistor to control the on and off states of the second control transistor respectively. Compared with the prior art, an amount of the transistors is reduced, thereby reducing a space required to be occupied by the gate driving circuit and then helping to realize a narrow border of the display device.

The display device provided by the present disclosure includes the gate driving circuit, thereby reducing a space required to be occupied by the gate driving circuit and then helping to realize a narrow border of the display device.

### BRIEF DESCRIPTION OF THE DRAWINGS

The drawings being a part of the specification are to provide a further understanding of the present disclosure. The present disclosure may be illustrated by the following embodiments in conjunction with the drawings, but that is not meant to limit the scope of the present disclosure.
Fig. 1 is a circuit diagram of an existing shift register unit for controlling light emission;
Fig.2 is a time sequence diagram showing each signal in the shift register unit for controlling light emission in the case that each transistor in the shift register unit for controlling light emission and a film transistor for controlling light emission of pixels are P-type transistors;
Fig.3 is a circuit diagram of a shift register unit of a display device according to an embodiment of the present disclosure;
Fig.4 is a time sequence diagram showing each signal in the shift register unit in the case that each transistor in the shift register unit and the film transistor for controlling the light emission of pixels are P-type transistors;

### DETAILED DESCRIPTION

The embodiment of the present disclosure may be described hereinafter in details in conjunction with the drawings. It should be understood that the embodiment described herein is merely an illustration of the present disclosure rather than a limitation thereof.

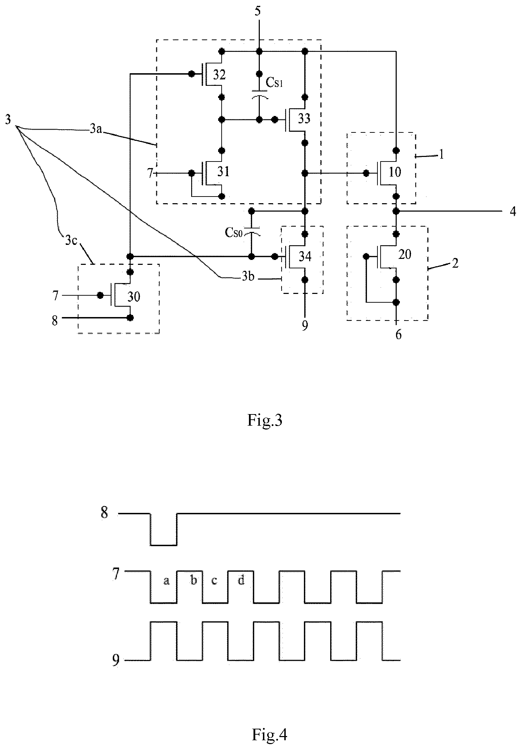

Fig.3 is a circuit diagram of a shift register unit of a display device according to an embodiment of the present disclosure. In this embodiment, as shown in Fig.3, a shift register unit includes a first module 1, a second module 2 and a control module 3. The first module 1 including a first control transistor 10 is configured to make an output terminal 4 of the shift register unit in a current stage output a high level signal, where a gate electrode of the first control transistor 10 is connected to the control module 3, a first electrode of the first control transistor 10 is connected to a high level signal input terminal 5, a second electrode of the first control transistor 10 is connected to the output terminal 4 of the shift register unit in the current stage; the control module 3 is configured to control on and off states of the first control transistor 10; and the second module 2 including a second control transistor 20 is configured to make an output terminal 4 of the shift register unit in the current stage output a low level signal, where a gate electrode and a first electrode of the second control transistor 20 are both connected to a low level signal input terminal 6, and a second electrode of the second control transistor 20 is connected to the output terminal 4 of the shift register unit in the current stage.

In this embodiment, the term "first electrode" represents a source electrode, and the term "second electrode" represents a drain electrode; alternatively, the term "first electrode" represents a drain electrode, and the term "second electrode" represents a source electrode.

The gate electrode of the second control transistor 20 is connected to the low level signal input terminal 6, i.e., the on and off states of the second control transistor 20 is directly controlled by a low level signal input into the low level signal input terminal 6, thereby it is not required to arrange specially an additional transistor to control the on and off states of the second control transistor 20 respectively. Compared with the prior art, an amount of the transistors in the shift register unit in this embodiment is reduced, thereby reducing a space occupied by the shift register unit and then facilitating to realize a narrow border of the display device.

The control module 3 includes an initial signal module 3c, a first capacitor Cso and a first control module 3a and a second control module 3b connected with the first capacitor Cso in parallel; the initial signal module 3c is configure to provide an initial signal to the first capacitor Cso, the first control module 3a and the second control module 3b, where a first terminal of the first capacitor Cso is connected to the initial signal module 3c, and a second terminal thereof is connected to the gate electrode of the first control transistor 10; the first control module 3a is configured to control on and off states of the first control transistor 10 based on the initial signal and a first clock signal input into a first clock signal input terminal 7; and the second control module 3b is configured to control on and off states of the first control transistor 10 based on the initial signal and a second clock signal input into a second clock signal input terminal 9.

The initial signal module 3c includes a signal control transistor 30, where a gate electrode of the signal control transistor 30 is connected to the first clock signal input terminal 7, a first electrode of the signal control transistor 30 is connected to an initial signal input terminal 8, and a second electrode of the signal control transistor 30 is connected to the first terminal of the first capacitor Cso, the first control module 3a and the second control module 3b respectively.

The first control module 3a includes a first transistor 31, a second transistor 32 and a third transistor 33. A gate electrode and a first electrode of the first transistor 31 are both connected to the first clock signal input terminal 7, a second electrode of the first transistor 31 is connected to a second electrode of the second transistor 32 and a gate electrode of the third transistor 33; a gate electrode of the second transistor 32 is connected to the second electrode of the signal control transistor 30, a first electrode of the second transistor 32 is connected to the high level signal input terminal 5, and the second electrode of the second transistor 32 is connected to a gate electrode of the third transistor 33; and the gate electrode of the third transistor 33 is connected to a first end of the second capacitor Csi, a second end of the second capacitor Csi is connected to the high level signal input terminal 5, a first electrode of the third transistor 33 is connected to the high level signal input terminal 5, and a second electrode of the third transistor 33 is connected to the gate electrode of the first control transistor 10 and the second end of the first capacitor Cso.

The second control module 3b includes a fourth transistor 34, where a gate electrode of the fourth transistor 34 is connected to the second electrode of the signal control transistor 30 and the first end of the first capacitor Cso, a first electrode of the fourth transistor 34 is connected to the second clock signal input terminal 9, and a second electrode of the fourth transistor 34 is connected to the gate electrode of the first control transistor 10 and the second end of the first capacitor Cso.

A working principle of the shift register unit may be illustrated hereinafter in conjunction with Fig.3 and Fig.4 in the case that each transistor in the shift register unit and the film transistor for controlling the light emission of pixels are P-type transistors. To be specific, as shown in Fig.3 and Fig.4, in a first phase a, an initial signal input into the initial signal input terminal 8 is at a low level, a first clock signal input into the first clock signal input terminal 7 is at a low level, and a second clock signal input into the second clock signal input terminal 9 is at a high level. In this case, the signal control transistor 30 and the first transistor 31 are turned on; the initial signal charges the first capacitor Csoand maintains charges on the first capacitor Cso, and the initial signal is input into the gate electrodes of the second transistor 32 and the fourth transistor 34, whereby the second transistor 32 and the fourth transistor 34 may be turned on; in a case that the second transistor 32 is turned on, a high level signal input into the high level signal input terminal 5 may be input into the gate electrode of the third transistor 33 via the first and the second electrodes of the second transistor 32, whereby the third transistor 33 may be turned off; in a case that the fourth transistor 34 is turned on, the second clock signal may be input into the gate electrode of the first control transistor 10, whereby the first control transistor 10 may be turned off. In this process, a low level signal is input into the gate electrode of the second control transistor 20 via the low level signal input terminal 6, and then the second control transistor 20 may be turned on, thereby the output terminal 4 of the shift register unit may output a low level signal, i.e., the output terminal 4 may output a turn-on signal.

In the second phase b, the initial signal turns to a high level, the first clock signal turns to a high level, and the second clock signal turns to a low level. In this case, the signal control transistor 30 and the first transistor 31 are turned off, and the initial signal in the first phase a maintained by the first capacitor Cso is input into the gate electrodes of the second transistor 32 and the fourth transistor 34 by the first capacitor Cso, whereby the second transistor 32 and the fourth transistor 34 may be turned on; in a case that the second transistor 32 is turned on, the high level signal input into the high level signal input terminal 5 may be input into the gate electrode of the third transistor 33 and the first end of the second capacitor Csi via the first and the second electrodes of the second transistor 32, whereby the third electrode 33 may be turned off, and the high level signal may charge the second capacitor Csi and maintain the charges thereon, in a case that the fourth transistor 34 is turned on, the second clock signal may be input into the gate electrode of the first control transistor 10 via the first and the second electrodes of the fourth transistor 34, whereby the first control transistor 10 may be turned on. In this process, the low level signal is input into the gate electrode of the second control transistor 20, whereby the second control transistor 20 may still remain an on state; however, the first control transistor 10 has been turned on, and a voltage of the high level signal is higher than a voltage of the low level signal, thereby the shift register unit may output a high level signal, i.e., the output terminal 4 may output a turn-off signal.

In the third phase c, the initial signal maintains at a high level, the first clock signal turns to a low level, and the second clock signal turns to a high level. In this case, the signal control transistor 30 and the first transistor 31 are turned on, the initial signal charges the first capacitor Cso and maintains charges thereon, and then the initial signal is input into the gate electrodes of the second transistor 32 and the fourth transistor 34, whereby the second transistor 32 and the fourth transistor 34 may be turned off; in a case that the first transistor 31 is turned on, the first clock signal may be input into the gate electrode of the third transistor 33 via the first and the second electrodes of the first transistor 31, whereby the third transistor 33 may be turned on; in a case that the third transistor 33 is turned on, the high level signal input into the high level signal input terminal 5 may be input into the gate electrode of the first control transistor 10 via the first and the second electrodes of the third transistor 33, whereby the first control transistor 10 may be turned off; meanwhile, the high level signal may further charge the second capacitor Csi and maintains charges thereon. In this process, the low level signal is input into the gate electrode of the second control transistor 20, whereby the second control transistor 20 may still remain turned on, thereby the shift register unit may output a low level signal, i.e., the output terminal 4 may output a turn-on signal.

In the fourth phase d, the initial signal holds a high level, the first clock signal turns to a high level, and the second clock signal turns to a low level. In this case, the signal control transistor 30 and the first transistor 31 are turned off, and the initial signal in the third phase c maintained by the first capacitor Cso is input into the gate electrodes of the second transistor 32 and the fourth transistor 34 by the first capacitor Cso, whereby the second transistor 32 and the fourth transistor 34 may be turned off; the high level signal in the third phase c maintained by the second capacitor Csi is input into the gate electrode of the third transistor 33 by the second capacitor Csi, whereby the third transistor 33 may be turned off; the initial signal in the third phase c maintained by the first capacitor Cso is input into the gate electrode of the first control transistor 10 by the first capacitor Cso, whereby the first control transistor 10 may be turned off. In this process, the low level signal is input into the gate electrode of the second control transistor 20, whereby the second control transistor 20 may still remain an on state, thereby the shift register unit may output a low level signal, i.e., the output terminal 4 may output a turn-on signal. In the subsequent phases, the third phase c and the fourth phase d may be repeated continually, whereby all the signals output by the output terminal 4 may be turn-on signals.

The working principle of the shift register unit is illustrated hereinabove in the case that each transistor in the shift register unit and the film transistor for controlling the light emission of pixels are P-type transistors, however the transistor in the shift register unit and the film transistor for controlling the light emission of pixels are not limited to P-type transistors. For example, each transistor in the shift register unit and the film transistor for controlling the light emission of pixels may be N-type transistors alternatively. In this case, by controlling the time sequences of the initial signal, the first clock signal and the second clock signal, the first control transistor 10 may be turned off only at one pulse period of time and may remain an on state during other period of time, thereby the shift register unit may output a turn-off signal only at one pulse period of time and may output turn-on signals during other period of time.

In the shift register unit of the display device provided by the present disclosure, the gate electrode of the second control transistor 20 is connected to the low level signal input terminal 6, i.e., the on and off states of the second control transistor 20 is directly controlled by the low level signal, thereby it is not required to arrange specially an additional transistor to control the on and off states of the second control transistor 20. Compared with the prior art, an amount of the transistors in the shift register unit of the display device provided by the present disclosure is reduced, thereby reducing a space occupied by the shift register unit and then facilitating to realize a narrow border of the display device.

A shift register of the display device includes a plurality of stages of the shift register units connected in series.

A gate driving circuit of the display device includes the shift register.

The gate driving circuit includes the shift register, whereby it is not required to arrange specially an additional transistor to control the on and off state of the second control transistor respectively. Compared with the prior art, an amount of the transistors is reduced, thereby reducing a space occupied by the shift register and the gate driving circuit and then facilitating to realize a narrow border of a display device.

The display device provided by the present disclosure includes a gate electrode and the gate driving circuit.

To be specific, the display device is an OLED display device.

The display device provided by the present disclosure includes the gate driving circuit, where a space required to be occupied by the gate driving circuit may be reduced, thereby facilitating to realize a narrow border of a display device.

It may be understood that, the above embodiments are merely the exemplary embodiments for illustrating a principle of the present disclosure, but the present disclosure is not limited thereto.

## Claims

1. A display device, comprising a gate electrode and a gate driving circuit, wherein the gate driving circuit comprises a shift register, wherein the shift register comprises multiple stages of a shift register unit, said shift register unit comprising a first module (1), a second module (2), a control module (3), a high level signal input terminal (5), a low level signal input terminal (6), an output terminal (4), a first clock signal input terminal (7) and a second clock signal input terminal (9);
the display device being adapted to provide a first clock signal input into the first clock signal input terminal, a second clock signal input into the second clock signal input terminal, a high level signal input into the high level signal input terminal and a low level signal input into the low level signal input terminal;
the control module (3) is configured to control on and off states of a first control transistor (10), wherein the control module (3) comprises an initial signal module (3c), a first capacitor (Cₛ₀) and a first control module (3a) and a second control module (3b) connected with the first capacitor (Cₛ₀) in parallel, a first end of the first capacitor (Cₛ₀) is connected to the initial signal module (3c), and a second end of the first capacitor (Cₛ₀) is connected to the gate electrode of the first control transistor (10);
wherein the initial signal module (3c) is configured to provide an initial signal to the first capacitor (Cso), the first control module (3a) and the second control module (3b);
wherein the first control module (3a) is configured to control on and off states of the first control transistor based on the initial signal and a first clock signal input into a first clock signal input terminal; and
the second control module (3b) is configured to control on and off states of the first control transistor based on the initial signal and a second clock signal input into a second clock signal input terminal;
wherein the initial signal module (3c) comprises a signal control transistor (30), wherein a gate electrode of the signal control transistor (30) is connected to a first clock signal input terminal (7), a first electrode of the signal control transistor (30) is connected to an initial signal input terminal (8), and a second electrode of the signal control transistor (30) is connected to the first end of the first capacitor (Cso), the first control module (3a) and the second control module (3b), wherein the initial signal module (3c) is configured to provide an initial signal to the first capacitor (Cso), the first control module (3a) and the second control module (3b);
wherein the first control module (3a) comprises a first transistor (31), a second transistor (32) and a third transistor (33);
wherein a gate electrode and a first electrode of the first transistor (31) are both connected to the first clock signal input terminal (7), a second electrode of the first transistor (31) is connected to a second electrode of the second transistor (32) and a gate electrode of the third transistor (33);
a gate electrode of the second transistor (32) is connected to the second electrode of the signal control transistor (30), and the second electrode of the second transistor (32) is connected to a gate electrode of the third transistor (33); and
a first electrode of the third transistor (33) is connected to the high level signal input terminal (5), and a second electrode of the third transistor (33) is connected to the gate electrode of the first control transistor (10) and the second end of the first capacitor (Cso);
**characterized in that**
the first module (1) comprises the first control transistor (10) configured to make the output terminal of the shift register unit in a current stage output a high level signal, wherein a gate electrode of the first control transistor (10) is connected to the control module, a first electrode of the first control transistor (10) is connected to the high level signal input terminal (5), and a second electrode of the first control transistor (10) is connected to the output terminal (4) of the shift register unit in the current stage;
the second module (2) comprising the second control transistor (20) is configured to make the output terminal (4) of the shift register unit in the current stage output a low level signal, wherein a gate electrode and a first electrode of the second control transistor (20) are both directly connected to the low level signal input terminal (6), and a second electrode of the second control transistor (20) is connected to the output terminal (4) of the shift register unit in the current stage;
the first control module (3a) comprises a second capacitor (Cs1) having a first end connected to the gate electrode of the third transistor (33) and a second end connected to a first electrode of the second transistor (32) and to the high level signal input terminal (5).

2. The shift register unit according to claim 1, wherein the second control module (3b) comprises a fourth transistor (34), wherein a gate electrode of the fourth transistor (34) is connected to the second electrode of the signal control transistor (30) and the first end of the first capacitor (Cso), a first electrode of the fourth transistor (34) is connected to the second clock signal input terminal (9), and a second electrode of the fourth transistor (34) is connected to the gate electrode of the first control transistor (10) and the second end of the first capacitor (Cₛ₀).

## Patentansprüche

1. Anzeigevorrichtung, umfassend eine Gate-Elektrode und eine Gate-Treiberschaltung umfasst, wobei die Gate-Treiberschaltung ein Schieberegister umfasst, wobei das Schieberegister mehrere Stufen einer Schieberegistereinheit umfasst, wobei die Schieberegistereinheit ein erstes Modul (1), ein zweites Modul (2), ein Steuermodul (3), einen Hochpegelsignal-Eingangsanschluss (5), einen Niedrigpegelsignal-Eingangsanschluss (6), einen Ausgangsanschluss (4), einen ersten Taktsignal-Eingangsanschluss (7) und einen zweiten Taktsignal-Eingangsanschluss (9) umfasst;
wobei die Anzeigevorrichtung so ausgelegt ist, dass sie ein erstes Taktsignal, das in den ersten Taktsignal-Eingangsanschluss eingespeist wird, ein zweites Taktsignal, das in den zweiten Taktsignal-Eingangsanschluss eingespeist wird, ein Hochpegelsignal, das in den Hochpegelsignal-Eingangsanschluss eingespeist wird, und ein Niedrigpegelsignal, das in den Niedrigpegelsignal-Eingangsanschluss eingespeist wird, bereitstellt;
wobei das Steuermodul (3) so ausgeführt ist, dass es Ein- und Aus-Zustände eines ersten Steuertransistors (10) steuert, wobei das Steuermodul (3) ein Anfangssignalmodul (3c), einen ersten Kondensator (Cₛ₀) und ein erstes Steuermodul (3a) und ein zweites Steuermodul (3b) umfasst, die mit dem ersten Kondensator (Cₛ₀) parallel geschaltet sind, wobei ein erstes Ende des ersten Kondensators (Cₛ₀) mit dem Anfangssignalmodul (3c) verbunden ist und ein zweites Ende des ersten Kondensators (Cₛ₀) mit der Gate-Elektrode des ersten Steuertransistors (10) verbunden ist; wobei das Anfangssignalmodul (3c) so ausgeführt ist, dass es ein Anfangssignal an den ersten Kondensator (Cₛ₀), das erste Steuermodul (3a) und das zweite Steuermodul (3b) anlegt;
wobei das erste Steuermodul (3a) so ausgeführt ist, dass es Ein- und Aus-Zustände des ersten Steuertransistors auf der Grundlage des Anfangssignals und eines ersten Taktsignals, das in einen ersten Taktsignal-Eingangsanschluss eingespeist wird, steuert; und
wobei das zweite Steuermodul (3b) so ausgeführt ist, dass es Ein- und Aus-Zustände des ersten Steuertransistors auf der Grundlage des Anfangssignals und eines zweiten Taktsignals, das in einen zweiten Taktsignal-Eingangsanschluss eingespeist wird, steuert;
wobei das Anfangssignalmodul (3c) einen Signalsteuertransistor (30) umfasst, wobei eine Gate-Elektrode des Signalsteuertransistors (30) mit einem ersten Taktsignal-Eingangsanschluss (7) verbunden ist, eine erste Elektrode des Signalsteuertransistors (30) mit einem Anfangssignal-Eingangsanschluss (8) verbunden ist und eine zweite Elektrode des Signalsteuertransistors (30) mit dem ersten Ende des ersten Kondensators (Cₛ₀), dem ersten Steuermodul (3a) und dem zweiten Steuermodul (3b) verbunden ist, wobei das Anfangssignalmodul (3c) so konfiguriert ist, dass es ein Anfangssignal an den ersten Kondensator (Cₛ₀), das erste Steuermodul (3a) und das zweite Steuermodul (3b) anlegt;
wobei das erste Steuermodul (3a) einen ersten Transistor (31), einen zweiten Transistor (32) und einen dritten Transistor (33) umfasst;
wobei eine Gate-Elektrode und eine erste Elektrode des ersten Transistors (31) beide mit dem ersten Taktsignal-Eingangsanschluss (7) verbunden sind und eine zweite Elektrode des ersten Transistors (31) mit einer zweiten Elektrode des zweiten Transistors (32) und einer Gate-Elektrode des dritten Transistors (33) verbunden ist; wobei eine Gate-Elektrode des zweiten Transistors (32) mit der zweiten Elektrode des Signalsteuertransistors (30) verbunden ist und die zweite Elektrode des zweiten Transistors (32) mit einer Gate-Elektrode des dritten Transistors (33) verbunden ist; und
wobei eine erste Elektrode des dritten Transistors (33) mit dem Hochpegelsignal-Eingangsanschluss (5) verbunden ist und eine zweite Elektrode des dritten Transistors (33) mit der Gate-Elektrode des ersten Steuertransistors (10) und dem zweiten Ende des ersten Kondensators (Cₛ₀) verbunden ist; **dadurch gekennzeichnet, dass**
das erste Modul (1) den ersten Steuertransistor (10) umfasst, der so ausgeführt ist, dass er den Ausgangsanschluss der Schieberegistereinheit in einer momentanen Stufe veranlasst, ein Hochpegelsignal auszugeben, wobei eine Gate-Elektrode des ersten Steuertransistors (10) mit dem Steuermodul verbunden ist, eine erste Elektrode des ersten Steuertransistors (10) mit dem Hochpegelsignal-Eingangsanschluss (5) verbunden ist und eine zweite Elektrode des ersten Steuertransistors (10) mit dem Ausgangsanschluss (4) der Schieberegistereinheit in der momentanen Stufe verbunden ist;
das zweite Modul (2), das den zweiten Steuertransistor (20) umfasst, so ausgeführt ist, dass es den Ausgangsanschluss (4) der Schieberegistereinheit in der momentanen Stufe veranlasst, ein Niedrigpegelsignal auszugeben, wobei eine Gate-Elektrode und eine erste Elektrode des zweiten Steuertransistors (20) beide direkt mit dem Niedrigpegelsignal-Eingangsanschluss (6) verbunden sind und eine zweite Elektrode des zweiten Steuertransistors (20) mit dem Ausgangsanschluss (4) der Schieberegistereinheit in der momentanen Stufe verbunden ist;
das erste Steuermodul (3a) einen zweiten Kondensator (Cs1) umfasst, dessen erstes Ende mit der Gate-Elektrode des dritten Transistors (33) verbunden ist und dessen zweites Ende mit einer ersten Elektrode des zweiten Transistors (32) und mit dem Hochpegelsignal-Eingangsanschluss (5) verbunden ist.

2. Schieberegistereinheit nach Anspruch 1, wobei das zweite Steuermodul (3b) einen vierten Transistor (34) umfasst, wobei eine Gate-Elektrode des vierten Transistors (34) mit der zweiten Elektrode des Signalsteuertransistors (30) und dem ersten Ende des ersten Kondensators (Cₛ₀) verbunden ist, eine erste Elektrode des vierten Transistors (34) mit dem zweiten Taktsignal-Eingangsanschluss (9) verbunden ist und eine zweite Elektrode des vierten Transistors (34) mit der Gate-Elektrode des ersten Steuertransistors (10) und dem zweiten Ende des ersten Kondensators (Cₛ₀) verbunden ist.

## Revendications

1. Dispositif d'affichage, comprenant une électrode de grille et un circuit d'attaque de grille, dans lequel le circuit d'attaque de grille comprend un registre à décalage, dans lequel le registre à décalage comprend plusieurs étages d'une unité de registre à décalage, ladite unité de registre à décalage comprenant un premier module (1), un deuxième module (2), un module de commande (3), une borne d'entrée de signal de niveau haut (5), une borne d'entrée de signal de niveau bas (6), une borne de sortie (4), une première borne d'entrée de signal d'horloge (7) et une deuxième borne d'entrée de signal d'horloge (9) ;
le dispositif d'affichage étant adapté pour fournir un premier signal d'horloge entré dans la première borne d'entrée de signal d'horloge, un deuxième signal d'horloge entré dans la deuxième borne d'entrée de signal d'horloge, un signal de niveau haut entré dans la borne d'entrée de signal de niveau haut et un signal de niveau bas entré dans la borne d'entrée de signal de niveau bas ;
le module de commande (3) est configuré pour commander les états passant et bloqué d'un premier transistor de commande (10), dans lequel le module de commande (3) comprend un module de signal initial (3c), un premier condensateur (Cₛ₀) et un premier module de commande (3a) et un deuxième module de commande (3b) connectés au premier condensateur (Cₛ₀) en parallèle, une première extrémité du premier condensateur (Cₛ₀) est connectée au module de signal initial (3c), et une deuxième extrémité du premier condensateur (Cₛ₀) est connectée à l'électrode de grille du premier transistor de commande (10) ;
dans lequel le module de signal initial (3c) est configuré pour fournir un signal initial au premier condensateur (Cₛ₀), au premier module de commande (3a) et au deuxième module de commande (3b) ;
dans lequel le premier module de commande (3a) est configuré pour commander les états passant et bloqué du premier transistor de commande sur la base du signal initial et d'un premier signal d'horloge entré dans une première borne d'entrée de signal d'horloge ; et
le deuxième module de commande (3b) est configuré pour commander les états passant et bloqué du premier transistor de commande sur la base du signal initial et d'un deuxième signal d'horloge entré dans une deuxième borne d'entrée de signal d'horloge ;
dans lequel le module de signal initial (3c) comprend un transistor de commande de signal (30), dans lequel une électrode de grille du transistor de commande de signal (30) est connectée à une première borne d'entrée de signal d'horloge (7), une première électrode du transistor de commande de signal (30) est connectée à une borne d'entrée de signal initial (8), et une deuxième électrode du transistor de commande de signal (30) est connectée à la première extrémité du premier condensateur (Cₛ₀), au premier module de commande (3a) et au deuxième module de commande (3b), dans lequel le module de signal initial (3c) est configuré pour fournir un signal initial au premier condensateur (Cₛ₀), au premier module de commande (3a) et au deuxième module de commande (3b) ;
dans lequel le premier module de commande (3a) comprend un premier transistor (31), un deuxième transistor (32) et un troisième transistor (33) ;
dans lequel une électrode de grille et une première électrode du premier transistor (31) sont toutes deux connectées à la première borne d'entrée de signal d'horloge (7), une deuxième électrode du premier transistor (31) est connectée à une deuxième électrode du deuxième transistor (32) et à une électrode de grille du troisième transistor (33) ;
une électrode de grille du deuxième transistor (32) est connectée à la deuxième électrode du transistor de commande de signal (30), et la deuxième électrode du deuxième transistor (32) est connectée à une électrode de grille du troisième transistor (33) ; et
une première électrode du troisième transistor (33) est connectée à la borne d'entrée de signal de niveau haut (5), et une deuxième électrode du troisième transistor (33) est connectée à l'électrode de grille du premier transistor de commande (10) et à la deuxième extrémité du premier condensateur (Cₛ₀) ;
**caractérisé en ce que**
le premier module (1) comprend le premier transistor de commande (10) configuré pour faire en sorte que la borne de sortie de l'unité de registre à décalage dans un étage courant émette un signal de niveau haut, dans lequel une électrode de grille du premier transistor de commande (10) est connectée au module de commande, une première électrode du premier transistor de commande (10) est connectée à la borne d'entrée de signal de niveau haut (5), et une deuxième électrode du premier transistor de commande (10) est connectée à la borne de sortie (4) de l'unité de registre à décalage dans l'étage courant ;
le deuxième module (2) comprenant le deuxième transistor de commande (20) est configuré pour faire en sorte que la borne de sortie (4) de l'unité de registre à décalage dans l'étage courant émette un signal de niveau bas, dans lequel une électrode de grille et une première électrode du deuxième transistor de commande (20) sont toutes deux directement connectées à la borne d'entrée de signal de niveau bas (6), et une deuxième électrode du deuxième transistor de commande (20) est connectée à la borne de sortie (4) de l'unité de registre à décalage dans l'étage courant ;
le premier module de commande (3a) comprend un deuxième condensateur (Cₛ₁) ayant une première extrémité connectée à l'électrode de grille du troisième transistor (33) et une deuxième extrémité connectée à une première électrode du deuxième transistor (32) et à la borne d'entrée de signal de niveau haut (5).

2. Unité de registre à décalage selon la revendication 1, dans laquelle le deuxième module de commande (3b) comprend un quatrième transistor (34), dans laquelle une électrode de grille du quatrième transistor (34) est connectée à la deuxième électrode du transistor de commande de signal (30) et à la première extrémité du premier condensateur (Cₛ₀), une première électrode du quatrième transistor (34) est connectée à la deuxième borne d'entrée de signal d'horloge (9), et une deuxième électrode du quatrième transistor (34) est connectée à l'électrode de grille du premier transistor de commande (10) et à la deuxième extrémité du premier condensateur (Cₛ₀).
